(19) Europäisches Patentamt
European Patent Office
Office européen des brevets

(11) **EP 1 901 509 A1**

(12) **EUROPEAN PATENT APPLICATION**

(43) Date of publication:
**19.03.2008 Bulletin 2008/12**

(51) Int Cl.:
***H04L 27/14*** (2006.01)   ***H03M 13/41*** (2006.01)

(21) Application number: **06254776.5**

(22) Date of filing: **14.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **BRITISH TELECOMMUNICATIONS public limited company London EC1A 7AJ (GB)**

(72) Inventor: **The designation of the inventor has not yet been filed**

(74) Representative: **Chabasseur, Vincent Robert BT Group Legal Intellectual Property Department PP C5A-BT Centre 81 Newgate Street London EC1A 7AJ (GB)**

(54) **M-GFSK receiver with a Viterbi-decoder having reduced trellis states**

(57)    This relates to a method of demodulating and decoding a convolutionaly encoded bit stream that has been modulated so as to form a continuous phase modulated signal. The signal is passed through a bank of Laurent filters, the outputs of which are passed to a processor running a Viterbi algorithm for demodulating the signal. The metrics of evaluating the most probable path in the Viterbi algorithm are calculated by including the redundancy in the signal introduced by the convolutional coding. Specifically, certain paths are excluded as impermissible from a knowledge of the encoding. As a result, the path selected by the Viterbi algorithm as being the most probable path corresponds to the data signal without the redundancy. This reduces or removes the need for a second Viterbi algorithm to remove the redundancy in the signal and reduces the processing required.

## Fig.6.

Laurent filtering/ decomposition

$r(t) = s(t) + n(t)$

$g_0(-t)$ → $nT$ → $r_{0,n}$

$g_1(-t)$ → $nT$ → $r_{1,n}$

$g_{M-1}(-t)$ → $nT$ → $r_{M-1,n}$

Viterbi algorithm → decision → Demap information symbols into information bits → Output data

**Description**

This invention relates to the decoding and demodulating of a frequency modulated signal formed by a sequence of symbols, in particular using a maximum likelihood algorithm.

The major limitations on capacity are available bandwidth and power, coupled with tight constraints on emissions outside the occupied bandwidth. These constraints require a capability to transmit data with high bandwidth efficiency while at the same time being tolerant both to equalisation error (amplitude and group delay) and to non-linearities (such as caused by saturated amplifiers).

There are several methods for increasing the information content of transmissions. These include the use of ever-greater bandwidth, as it becomes technically feasible by making use of higher carrier frequencies. However, carrier frequencies are a scarce resource, and operators are not usually permitted to select a frequency of their choice. Higher frequencies also tend to be subject to greater attenuation and require greater power to generate and amplify.

Some systems, when required to transmit a signal requiring a higher data rate than a single channel can provide, are arranged to make use of two or more channels, each carrying part of the data.

Digital amplitude modulation systems may operate in a binary "on/off' (1/0) mode. To avoid loss of synchronisation with the carrier, it is usual to use two non-zero amplitudes. If these are positive and negative values (of the same or different magnitudes) they may be also considered as a phase shift: a "1" being indicated by a 180˚ shift in the phase of the carrier signal compared to the phase of a "zero". Other modulation schemes use other phase shifts, for example using multiples of 45 degrees - known as 8PSK (eight-phase shift keying), as is used in the current state-of-the-art Internet Service Provider (ISP) backbone connection market segment, using Trellis Coded Modulation modems fitting into a 72MHz satellite transponder to produce a bit rate of 155Mbit/s. The use of both phase and amplitude shifts is known as Quadrature Amplitude Modulation (QAM).

Such schemes allow several binary digits ("bits") to be transmitted together, for example a system using a so-called "constellation" of sixteen "symbols", each represented by a different phase/amplitude state, would allow each individual symbol to represent a different four-bit word. The number of modulation states required increases exponentially with the number of binary digits to be represented by each symbol. For ease of conversion, constellations are usually selected to have a number of symbols which is some power of two, so that each symbol can represent a group of binary digits (bits).

Instead of amplitude or phase, different symbols may be represented by different frequencies. This is known as frequency shift keying (FSK). In order to economise on bandwidth, the frequency shifts are generally selected to be the minimum necessary to be distinguishable from each other, (minimum shift keying or MSK). To avoid high frequency spectral spread, the frequency shifts are generally shaped such that the frequency shifts follow a smooth Gaussian waveform rather than a square wave shape: thus the system is known as Gaussian minimum shift keying (GMSK).

In any digital system the individual symbols used must be sufficiently different from each other to be distinguishable by the receiver. However, the greater such a difference is, the more bandwidth is required. It will be apparent that any system other than a simple binary system (or the special case of a 3PSK system) will require that some symbol transitions will be greater than others. The increase in speed obtained by a multiple-level system therefore requires either a greater carrier-to-noise ratio than a simple binary system in order to allow the different levels to be clearly distinguishable, or a greater bandwidth in order to accommodate the same minimum shift between phase/amplitude states. Efficiency of use of bandwidth is obtained only if the gain in speed is greater than the increase in bandwidth required to achieve it. In the case of frequency shift keying a multiple-level system would require an increase in bandwidth proportional to the number of symbols used, if the minimum difference between frequencies is to be maintained, so no advantage is gained compared with the use of a plurality of binary channels occupying the same bandwidth.

However, frequency shift keying has advantages in certain circumstances such as in satellite links, as the cost of setting up earth stations is affected by the required equalisation error across the signal bandwidth and this becomes more of an issue for wide-band signals and in particular for systems using phase shift keying. High tolerance to non-linearities in the channel is also desirable, as satellite channels include one or more elements in series that could be running close to or at saturation point. It is therefore desirable in such circumstances to optimise the bandwidth utilisation of FSK systems.

In a known demodulator system, a bank of Laurent filters followed by a Viterbi sequence detector can be used to demodulate an encoded sequence. Because the output from this Viterbi sequence detector (which is also known as a demodulator) is still encoded, a second Viterbi algorithm is performed in order to carry out the decoding. This can be undesirably processor intensive.

According to one aspect of the present invention, there is provided a method as claimed in claim 1. A further aspect of the invention is specified in claim 11.

The invention will now be described by way of example with reference to the following drawings in which

Fig 1 shows a communications system in accordance with the present invention

Fig 2a shows three uncoded streams of a four bit word and a coder circuit for coding the remaining stream corresponding to the least significant bit of the word
Fig 2b shows a trellis state diagram for the coder circuit of Fig 2a
Fig 3 shows Laurent functions for 32-GFSK with h = 1/32 and BT = 0.5
Fig 4 shows a spectrum of a 32GFSK signal with BT = 0.5 and h = 1/32
Fig 5 shows a comparison of 4/5 coded 32-GFSK with 64-QAM
Fig 6 shows a decoder/demodulator system
Fig 7 a trellis diagram for a viterbi algorithm
Fig 8 shows a prior art decoder/demodulator system
Fig 9 shows a trellis path with no errors in the transmission
Fig 10 shows a branched trellis path with errors in the transmission
Fig 11 shows trellis paths for the demodulator of Fig 8

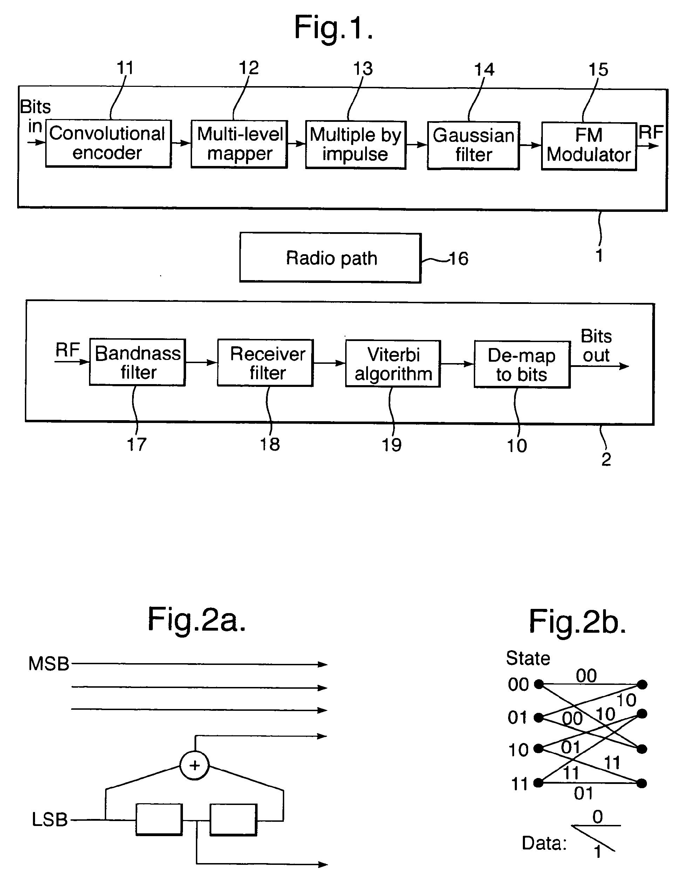

Fig 1 shows a transmitter 1 for transmitting encoded and modulated RF signals over a radio path 16 to a receiver 2, where the signals are demodulated and decoded. The various processing steps carried out at the transmitter and receiver, each of which may be distributed over a number of different locations, are functionally indicated in Fig 1. On the transmitter side of the radio path, a data stream (Bits in) is input at a convolutional encoder stage 11. The encoder 11 is configured to treat the incoming data as a series of four bit words, and to encode the least significant bit of each word.
The encoding is represented in Fig 2a, which shows three bit streams for the three most significant bits (MSB) respectively and on bit stream for the least significant bit (LSB) of each four bit word. Coding is applied to the LSB as indicated schematically by a conceptual coder circuit which in this example is formed by a shift register with two sequential delay stages or "blocks" D1, D2 and an exclusive OR gate (+). The XOR gate has respective inputs connected to the LSB stream before and after the bits enter/exit the shift register so as to provide a first encoded output. A tap between the two delay stages provides a second encoded output. Thus, a 5 bit output word is constructed from each 4 bit input word. The code applied to the LSB is known as a ½ rate code (the other three bits passing through without any coding). The resulting coding of the four bit words is known as a 4/5 rate (5,2) code.
At a Multi-Level Mapper stage 12, the encoded bits are mapped to symbols using natural binary mapping. This is done using an alphabet of thirty two symbols (since the words now encoded each have five bits). The thirty two symbols are represented by different amplitudes symmetrical about zero, i.e. $\pm 1, \pm 3, \pm 5, .... \pm (M\text{-}1)$, where M= 32 in this example.
In the next stage 13, these levels are multiplied by impulses of value 1 to produce impulses weighted by the values of the amplitudes.
The impulses are applied to a filter stage, here a Gaussian filter stage 14, to produce a set of impulses having a Gaussian shape, i.e. smooth waveforms with no negative or oscillatory characteristics (the unit impulses of the previous state are intended to properly excite the Gaussian filter). The Gaussian filter has the frequency response

$$f(t) = \frac{1}{2T}\left\{ erfc\left(2\pi B\frac{t-T/2}{\sqrt{\ln 2}}\right) - erfc\left(2\pi B\frac{t+T/2}{\sqrt{\ln 2}}\right)\right\}$$

where $B$ is the -3dB bandwidth of the filter and $T$ is the symbol period. The product $BT$ is defined as the *normalised bandwidth.* As $BT \to \infty$, the filter output closely resembles the impulse input but, as $BT$ is reduced, the output becomes smoother and is spread more in time. There is a trade-off in choosing the value of $BT$ to give good spectral efficiency and Inter-Symbol Interference (ISI). $BT$ is set to 0.5 with this implementation which spreads the response somewhat over the two adjacent symbols (the response of the filter is sufficiently broad such that in response to one symbol, the filter response will significantly overlap at least the two adjacent symbol). The scheme is therefore partial response and deliberately introduces ISI in order to benefit from improved spectral efficiency.
The phase response of the filter is the integral of the frequency response, i.e.

$$q(t) = \int_{-\infty}^{t} f(\tau)d\tau \qquad\qquad (1)$$

The pulse *f(t)* from (1) is time limited to the interval (0, *LT*) and satisfies the following two conditions:

$$f(t) = f(LT - t)$$

$$\int_{-\infty}^{LT} f(\tau)d\tau = q(LT) = 1/2$$

These two conditions effectively truncate the response from the filter to be $L$ symbol periods. The value of $L$ is set to 4 in this implementation, since the amount of energy spreading into symbols more than 2 distant from the current symbol is not significant. The final stage in the modulation process is to translate the output from the Gaussian filter to the carrier frequency. Thus the output of the Gaussian filter is applied to a frequency modulator 15, here a voltage-controlled oscillator or similar device, to produce an RF, typically on a carrier of 1 - 40GHz signal for transmission over the radio path 16. The complex envelope of the resulting M-GFSK signals has the form

$$s(t, \boldsymbol{\alpha}) = \sqrt{\frac{E_s}{T}} \exp(j\theta(t, \boldsymbol{\alpha})) \qquad (2)$$

with

$$\theta(t, \boldsymbol{\alpha}) = 2\pi h \sum_{k=-\infty}^{n} \alpha_k q(t - kT), \quad nT \leq t \leq (n+1)T$$

where $\theta(t,\alpha)$ is the *carrier phase,* $E_s$ is the symbol energy, $T$ is the symbol interval, $\alpha=\{\alpha_k\}$ is the sequence of *M*-ary symbols to be modulated with possible values $\{\pm 1, \pm 3, ..., \pm(M\text{-}1)\}$, $h = m/p$ is the modulation index ($m$ and $p$ are relatively prime integers), and $q(t)$ is the *phase response* of the system which, as stated earlier is the integral of a frequency pulse set to be Gaussian.

Equation (2) shows that the signal is in fact a frequency modulation or continuous phase modulation (CPM) with constant envelope $\sqrt{(E_s/T)}$. The symbol rate in the implementation is set (normalised) to 1Hz.

The above modulation is referred to a multiple value Gaussian frequency shift keying, or M-GFSK, since each symbol corresponds to a different frequency "key". The radio path will normally extend to a satellite for re-transmission to earth, but may instead be between a transmitter and receiver on earth, which are preferably in a light of sight arrangement. M-GFSK was specifically designed for satellite and microwave links, but will also find applications where low power consumption is important, e.g. in portable devices.

One important aspect of the encoding scheme is that the nature of the modulation, in particular the way in which the binary words are mapped to the symbols, is taken into account. M-GFSK is essentially a one dimensional modulation scheme in which the symbols can be represented along one axis, distance along the axis being indicative of the frequency of the symbol (as opposed to QAM for example, in which the symbols require a two dimensional space or area to be represented). Consequently, in the present mapping process, words that have consecutive values of magnitude are mapped to consecutive symbols. By encoding the least significant bit of each word, the encoding is used to help distinguish between adjacent symbols in the case of an error.

It has been appreciated that an error is more likely to cause confusion between adjacent symbols since these will have close frequency values, rather than symbols that are far apart from one another along the path, since these will have widely differing frequencies. Thus, by transmitting the remaining bits of each word without encoding, bandwidth and processing requirements are reduced without significantly increasing the number of errors.

This is called Trellis-coded modulation and is particularly beneficial for M-GFSK with large M, M (>4)

At the receiver 2, there is provided a Band-pass filter 17 set to 10Hz bandwidth to admit the wanted signal but to band-limit noise into the subsequent demodulator stages. It is a 512-tap Butterworth filter but is not directly involved in the demodulation process.

Signals from the band pass filter are passed to a demodulator formed by a Receiver filter 18 followed by a Viterbi stage for running a Viterbi algorithm.

This filter bank consists of filters designed using a Laurent Decomposition process for coherent detection of the received GMFSK signal. This process is now briefly described.

The carrier phase θ(t,α) in equation (2) can be re-written in two parts as follows:

$$\theta(t,\alpha) = \pi h \sum_{k=-\infty}^{n-L} \alpha_k + 2\pi h \sum_{k=n-L+1}^{n} \alpha_k q(t-kT)$$

$$= \theta_{n-L} + \varphi(t,\alpha) \qquad nT \le t \le (n+1)T$$

That is,

$$\theta_{n-L} = \pi h \sum_{k=-\infty}^{n-L} \alpha_k$$

$$\varphi(t,\alpha) = 2\pi h \sum_{k=n-L+1}^{n-L} \alpha_k q(t-kT)$$

The $\theta_{n-L}$ is the combined phase state up to the $n$th symbol. The $\varphi(t,\alpha)$ is the Inter-symbol Inteference (ISI) that extends into the $n$th symbol. This separation enables the state of the coded M-GFSK signal at any time $t = nT$ to be expressed as the combined phase state $\theta_{n-L}$, the correlative state vector $(\alpha_{n-L+1}, ....\alpha_{n-2}, \alpha_{n-1})$ and the current state of the convolutional encoder $(s_{n-1}, s_{n-2}, ....., s_{n-v+1})$ [2] and is denoted as

$$S_n = (\theta_{n-L}, \alpha_{n-L+1}, ....\alpha_{n-2}, \alpha_{n-1}, s_{n-1}, s_{n-2}, ......, s_{n-v+1})$$

For the partial response of length $LT$, and for odd $m$ (=1 in this case) the total number of states is

$$N_s = 2p2^{v-1+\mu(L-1)} \qquad (3)$$

In this implementation $p$ is the denominator of the modulation index (=1), $v$ is the constraint length of the code (=3), the code rate $r = \mu / \eta = 4/5$ and $L$ (=4) is the symbol duration of the signal pulse.

The state vector becomes

$$S_n = (\theta_{n-4}, \alpha_{n-3}, \alpha_{n-2}, \alpha_{n-1}, s_{n-1}, s_{n-2})$$

The total number of states in the system is $N_s$ = 1048576 according to equation (3).

Performing Laurent decomposition, the complex envelope of the M-GFSK signal can be exactly expressed [3] as

$$s(t, \boldsymbol{\alpha}) = \sqrt{\frac{E_s}{T}} \sum_{k=0}^{N-1} \sum_{n} a_{k,n} g_k(t - nT) \qquad (4)$$

where $N = M^{L-1}(M-1)$. The key parameters in equation (4) are the so-called Laurent functions (LF's) $g_k(t)$ and the pseudo-symbols $\alpha_{k,n}$.

For the values of $M$ and $L$ in this implementation, $N = 1015808$ for the exact decomposition, but as shown in [3], most of the signal energy is concentrated in the first ($M$-1) components which are referred to as the *principal* Laurent Components (LCs). In this implementation, only the principal LCs are used.

The phase state of the signal is a function of the transmitted symbols and of the encoder. Therefore, when representing 32-GFSK with the 31 principal Laurent components, the state vector of the trellis-coded 32-GFSK is the combination of the phase state of uncoded 32-GFSK and the state of the convolutional encoder.

$$\mathbf{S}_n^{\bullet} = (\theta_{n-1}, s_{n-1}, s_{n-2})$$

In this case the total number of states is reduced to

$$N_s^{\bullet} = \begin{cases} p2^{\nu-1} & m \text{ even} \\ 2p2^{\nu-1} & m \text{ odd} \end{cases}$$

For the considered rate-4/5 (5,2)-encoded 32-GFSK, $m=1$, $p=32$, $\nu=3$ and $N_s^{\bullet} = 256$.

By using 31 principal LC's a good trade-off between approximation quality and receiver complexity is achieved. Note that at least 32-fold increase in states is required if more LC's are included. Therefore, a Viterbi decoder which searches a trellis diagram with 256 states is required at the receiver which represents a simplification over the number required for the exact demcomposition for uncoded 32-GFSK calculated from (3).

The 31 principal LCs for 32-GFSK are shown in table 2.

| $k$ | $e_{0,4}^{(k)}\,e_{0,3}^{(k)}\,e_{0,2}^{(k)}\,e_{0,1}^{(k)}\,e_{0,0}^{(k)}$ | $g_k(t)$ | $\alpha_{k,n}$ |
|---|---|---|---|
| 0 | 00000 | $c_0^{(0)}(t)c_0^{(1)}(t)c_0^{(2)}(t)c_0^{(3)}(t)c_0^{(4)}(t)$ | $b_{0,n}^{(0)}b_{0,n}^{(1)}b_{0,n}^{(2)}b_{0,n}^{(3)}b_{0,n}^{(4)}$ |
| 1 | 00001 | $c_0^{(0)}(t+T)c_0^{(1)}(t)c_0^{(2)}(t)c_0^{(3)}(t)c_0^{(4)}(t)$ | $b_{0,n}^{(0)}b_{0,n-1}^{(1)}b_{0,n}^{(2)}b_{0,n}^{(3)}b_{0,n}^{(4)}$ |
| 2 | 00010 | $c_0^{(0)}(t)c_0^{(1)}(t+T)c_0^{(2)}(t)c_0^{(3)}(t)c_0^{(4)}(t)$ | $b_{0,n}^{(0)}b_{0,n}^{(1)}b_{0,n-1}^{(2)}b_{0,n}^{(3)}b_{0,n}^{(4)}$ |
| 3 | 00011 | $c_0^{(0)}(t+T)c_0^{(1)}(t+T)c_0^{(2)}(t)c_0^{(3)}(t)c_0^{(4)}(t)$ | $b_{0,n}^{(0)}b_{0,n-1}^{(1)}b_{0,n-1}^{(2)}b_{0,n}^{(3)}b_{0,n}^{(4)}$ |
| 4 | 00100 | $c_0^{(0)}(t)c_0^{(1)}(t)c_0^{(2)}(t+T)c_0^{(3)}(t)c_0^{(4)}(t)$ | $b_{0,n}^{(0)}b_{0,n}^{(1)}b_{0,n}^{(2)}b_{0,n-1}^{(3)}b_{0,n}^{(4)}$ |
| 5 | 00101 | $c_0^{(0)}(t+T)c_0^{(1)}(t)c_0^{(2)}(t+T)c_0^{(3)}(t)c_0^{(4)}(t)$ | $b_{0,n}^{(0)}b_{0,n-1}^{(1)}b_{0,n}^{(2)}b_{0,n-1}^{(3)}b_{0,n}^{(4)}$ |
| 6 | 00110 | $c_0^{(0)}(t)c_0^{(1)}(t+T)c_0^{(2)}(t+T)c_0^{(3)}(t)c_0^{(4)}(t)$ | $b_{0,n}^{(0)}b_{0,n}^{(1)}b_{0,n-1}^{(2)}b_{0,n-1}^{(3)}b_{0,n}^{(4)}$ |
| 7 | 00111 | $c_0^{(0)}(t+T)c_0^{(1)}(t+T)c_0^{(2)}(t+T)c_0^{(3)}(t)c_0^{(4)}(t)$ | $b_{0,n}^{(0)}b_{0,n-1}^{(1)}b_{0,n-1}^{(2)}b_{0,n-1}^{(3)}b_{0,n}^{(4)}$ |
| 8 | 01000 | $c_0^{(0)}(t)c_0^{(1)}(t)c_0^{(2)}(t)c_0^{(3)}(t+T)c_0^{(4)}(t)$ | $b_{0,n}^{(0)}b_{0,n}^{(1)}b_{0,n}^{(2)}b_{0,n}^{(3)}b_{0,n-1}^{(4)}$ |
| 9 | 01001 | $c_0^{(0)}(t+T)c_0^{(1)}(t)c_0^{(2)}(t)c_0^{(3)}(t+T)c_0^{(4)}(t)$ | $b_{0,n}^{(0)}b_{0,n-1}^{(1)}b_{0,n}^{(2)}b_{0,n}^{(3)}b_{0,n-1}^{(4)}$ |
| 10 | 01010 | $c_0^{(0)}(t)c_0^{(1)}(t+T)c_0^{(2)}(t)c_0^{(3)}(t+T)c_0^{(4)}(t)$ | $b_{0,n}^{(0)}b_{0,n}^{(1)}b_{0,n-1}^{(2)}b_{0,n}^{(3)}b_{0,n-1}^{(4)}$ |
| 11 | 01011 | $c_0^{(0)}(t+T)c_0^{(1)}(t+T)c_0^{(2)}(t)c_0^{(3)}(t+T)c_0^{(4)}(t)$ | $b_{0,n}^{(0)}b_{0,n-1}^{(1)}b_{0,n-1}^{(2)}b_{0,n}^{(3)}b_{0,n-1}^{(4)}$ |
| 12 | 01100 | $c_0^{(0)}(t)c_0^{(1)}(t)c_0^{(2)}(t+T)c_0^{(3)}(t+T)c_0^{(4)}(t)$ | $b_{0,n}^{(0)}b_{0,n}^{(1)}b_{0,n}^{(2)}b_{0,n-1}^{(3)}b_{0,n-1}^{(4)}$ |

| $k$ | $e_{0,4}^{(k)}\ e_{0,3}^{(k)}\ e_{0,2}^{(k)}\ e_{0,1}^{(k)}\ e_{0,0}^{(k)}$ | $g_k(t)$ | $\alpha_{k,n}$ |
|---|---|---|---|
| 13 | 0 1 1 0 1 | $c_0^{(0)}(t+T)c_0^{(1)}(t)c_0^{(2)}(t+T)c_0^{(3)}(t+T)c_0^{(4)}(t)$ | $b_{0,n-1}^{(0)}b_{0,n}^{(1)}b_{0,n-1}^{(2)}b_{0,n-1}^{(3)}b_{0,n}^{(4)}$ |
| 14 | 0 1 1 1 0 | $c_0^{(0)}(t)c_0^{(1)}(t+T)c_0^{(2)}(t+T)c_0^{(3)}(t+T)c_0^{(4)}(t)$ | $b_{0,n}^{(0)}b_{0,n-1}^{(1)}b_{0,n-1}^{(2)}b_{0,n-1}^{(3)}b_{0,n}^{(4)}$ |
| 15 | 0 1 1 1 1 | $c_0^{(0)}(t+T)c_0^{(1)}(t+T)c_0^{(2)}(t+T)c_0^{(3)}(t+T)c_0^{(4)}(t)$ | $b_{0,n-1}^{(0)}b_{0,n-1}^{(1)}b_{0,n-1}^{(2)}b_{0,n-1}^{(3)}b_{0,n}^{(4)}$ |
| 16 | 1 0 0 0 0 | $c_0^{(0)}(t)c_0^{(1)}(t)c_0^{(2)}(t)c_0^{(3)}(t)c_0^{(4)}(t+T)$ | $b_{0,n}^{(0)}b_{0,n}^{(1)}b_{0,n}^{(2)}b_{0,n}^{(3)}b_{0,n-1}^{(4)}$ |
| 17 | 1 0 0 0 1 | $c_0^{(0)}(t+T)c_0^{(1)}(t)c_0^{(2)}(t)c_0^{(3)}(t)c_0^{(4)}(t+T)$ | $b_{0,n-1}^{(0)}b_{0,n}^{(1)}b_{0,n}^{(2)}b_{0,n}^{(3)}b_{0,n-1}^{(4)}$ |
| 18 | 1 0 0 1 0 | $c_0^{(0)}(t)c_0^{(1)}(t+T)c_0^{(2)}(t)c_0^{(3)}(t)c_0^{(4)}(t+T)$ | $b_{0,n}^{(0)}b_{0,n-1}^{(1)}b_{0,n}^{(2)}b_{0,n}^{(3)}b_{0,n-1}^{(4)}$ |
| 19 | 1 0 0 1 1 | $c_0^{(0)}(t+T)c_0^{(1)}(t+T)c_0^{(2)}(t)c_0^{(3)}(t)c_0^{(4)}(t+T)$ | $b_{0,n-1}^{(0)}b_{0,n-1}^{(1)}b_{0,n}^{(2)}b_{0,n}^{(3)}b_{0,n-1}^{(4)}$ |
| 20 | 1 0 1 0 0 | $c_0^{(0)}(t)c_0^{(1)}(t)c_0^{(2)}(t+T)c_0^{(3)}(t)c_0^{(4)}(t+T)$ | $b_{0,n}^{(0)}b_{0,n}^{(1)}b_{0,n-1}^{(2)}b_{0,n}^{(3)}b_{0,n-1}^{(4)}$ |
| 21 | 1 0 1 0 1 | $c_0^{(0)}(t+T)c_0^{(1)}(t)c_0^{(2)}(t+T)c_0^{(3)}(t)c_0^{(4)}(t+T)$ | $b_{0,n-1}^{(0)}b_{0,n}^{(1)}b_{0,n-1}^{(2)}b_{0,n}^{(3)}b_{0,n-1}^{(4)}$ |
| 22 | 1 0 1 1 0 | $c_0^{(0)}(t)c_0^{(1)}(t+T)c_0^{(2)}(t+T)c_0^{(3)}(t)c_0^{(4)}(t+T)$ | $b_{0,n}^{(0)}b_{0,n-1}^{(1)}b_{0,n-1}^{(2)}b_{0,n}^{(3)}b_{0,n-1}^{(4)}$ |
| 23 | 1 0 1 1 1 | $c_0^{(0)}(t+T)c_0^{(1)}(t+T)c_0^{(2)}(t+T)c_0^{(3)}(t)c_0^{(4)}(t+T)$ | $b_{0,n-1}^{(0)}b_{0,n-1}^{(1)}b_{0,n-1}^{(2)}b_{0,n}^{(3)}b_{0,n-1}^{(4)}$ |
| 24 | 1 0 0 0 | $c_0^{(0)}(t)c_0^{(1)}(t)c_0^{(2)}(t)c_0^{(3)}(t+T)c_0^{(4)}(t+T)$ | $b_{0,n}^{(0)}b_{0,n}^{(1)}b_{0,n}^{(2)}b_{0,n-1}^{(3)}b_{0,n-1}^{(4)}$ |

(continued)

| $k$ | $e_{0,4}^{(k)}\,e_{0,3}^{(k)}\,e_{0,2}^{(k)}\,e_{0,1}^{(k)}\,e_{0,0}^{(k)}$ | $g_k(t)$ | $\alpha_{k,n}$ |
|---|---|---|---|
| 25 | 1 1 0 0 1 | $c_0^{(0)}(t+T)c_0^{(1)}(t)c_0^{(2)}(t)c_0^{(3)}(t+T)c_0^{(4)}(t+T)$ | $b_{0,n-1}^{(0)}b_{0,n}^{(1)}b_{0,n}^{(2)}b_{0,n-1}^{(3)}b_{0,n-1}^{(4)}$ |
| 26 | 1 1 0 1 0 | $c_0^{(0)}(t)c_0^{(1)}(t+T)c_0^{(2)}(t)c_0^{(3)}(t+T)c_0^{(4)}(t+T)$ | $b_{0,n}^{(0)}b_{0,n-1}^{(1)}b_{0,n}^{(2)}b_{0,n-1}^{(3)}b_{0,n-1}^{(4)}$ |
| 27 | 1 1 0 1 1 | $c_0^{(0)}(t+T)c_0^{(1)}(t+T)c_0^{(2)}(t)c_0^{(3)}(t+T)c_0^{(4)}(t+T)$ | $b_{0,n-1}^{(0)}b_{0,n-1}^{(1)}b_{0,n}^{(2)}b_{0,n-1}^{(3)}b_{0,n-1}^{(4)}$ |
| 28 | 1 1 1 0 0 | $c_0^{(0)}(t)c_0^{(1)}(t)c_0^{(2)}(t+T)c_0^{(3)}(t+T)c_0^{(4)}(t+T)$ | $b_{0,n}^{(0)}b_{0,n}^{(1)}b_{0,n-1}^{(2)}b_{0,n-1}^{(3)}b_{0,n-1}^{(4)}$ |
| 29 | 1 1 1 0 1 | $c_0^{(0)}(t+T)c_0^{(1)}(t)c_0^{(2)}(t+T)c_0^{(3)}(t+T)c_0^{(4)}(t+T)$ | $b_{0,n-1}^{(0)}b_{0,n}^{(1)}b_{0,n-1}^{(2)}b_{0,n-1}^{(3)}b_{0,n-1}^{(4)}$ |
| 30 | 1 1 1 1 0 | $c_0^{(0)}(t)c_0^{(1)}(t+T)c_0^{(2)}(t+T)c_0^{(3)}(t+T)c_0^{(4)}(t+T)$ | $b_{0,n}^{(0)}b_{0,n-1}^{(1)}b_{0,n-1}^{(2)}b_{0,n-1}^{(3)}b_{0,n-1}^{(4)}$ |

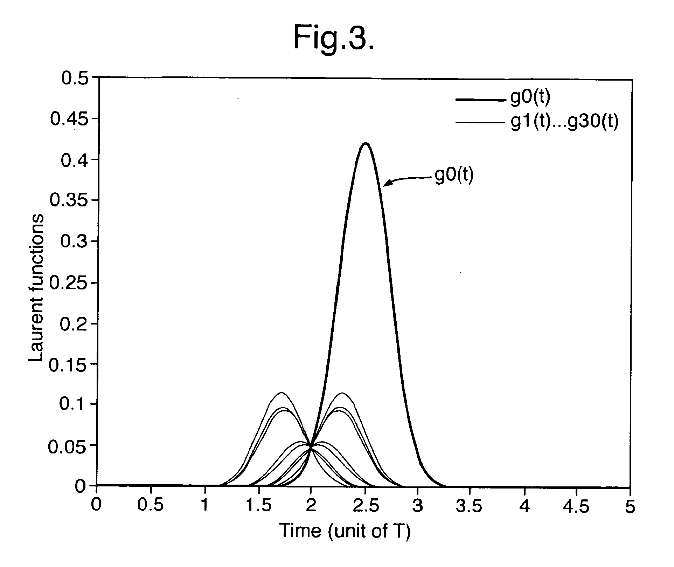

Figure 3 shows the shapes of the principal Laurent Functions for 32-GFSK with h = 1/32 and BT = 0.5.

Note that the higher functions contain much less energy than the first function $g_0$. There are 30 plots in the higher functions, but it can be seen that many of them are on top of each other, representing a further saving in the filters. In fact, in the implementation that we tried, only 7 filters are used.

As an example for 32-GFSK the pseudo-symbols $\alpha_{k,n}$ of the first three Laurent components is (see table 2)

$$a_{0,n} = b_{0,n}^{(0)} b_{0,n}^{(1)} b_{0,n}^{(2)} b_{0,n}^{(3)} b_{0,n}^{(4)}$$

$$a_{1,n} = b_{0,n-1}^{(0)} b_{0,n}^{(1)} b_{0,n}^{(2)} b_{0,n}^{(3)} b_{0,n}^{(4)}$$

$$a_{2,n} = b_{0,n}^{(0)} b_{0,n-1}^{(1)} b_{0,n}^{(2)} b_{0,n}^{(3)} b_{0,n}^{(4)}$$

To calculate the $b$'s:

$$b_{0,n}^{(0)} = \exp\left\{ jh\pi \sum_{m=0}^{n} \gamma_{m,0} \right\} = b_{0,n-1}^{(0)} e^{jh\pi\gamma_{n,0}}$$

$$b_{0,n}^{(1)} = \exp\left\{ j2h\pi \sum_{m=0}^{n} \gamma_{m,1} \right\} = b_{0,n-1}^{(1)} e^{j2h\pi\gamma_{n,1}}$$

$$b_{0,n}^{(2)} = \exp\left\{ j4h\pi \sum_{m=0}^{n} \gamma_{m,2} \right\} = b_{0,n-1}^{(2)} e^{j4h\pi\gamma_{n,2}} \qquad (18)$$

$$b_{0,n}^{(3)} = \exp\left\{ j8h\pi \sum_{m=0}^{n} \gamma_{m,3} \right\} = b_{0,n-1}^{(3)} e^{j8h\pi\gamma_{n,3}}$$

$$b_{0,n}^{(4)} = \exp\left\{ j16h\pi \sum_{m=0}^{n} \gamma_{m,4} \right\} = b_{0,n-1}^{(4)} e^{j16h\pi\gamma_{n,4}}$$

Substituting (18) into (17) we get

$$a_{0,n} = e^{jh\pi\gamma_{n,0}} e^{j2h\pi\gamma_{n,1}} e^{j4h\pi\gamma_{n,2}} e^{j8h\pi\gamma_{n,3}} e^{j16h\pi\gamma_{n,4}} b_{0,n-1}^{(0)} b_{0,n-1}^{(1)} b_{0,n-1}^{(2)} b_{0,n-1}^{(3)} b_{0,n-1}^{(4)}$$

$$a_{1,n} = e^{j2h\pi\gamma_{n,1}} e^{j4h\pi\gamma_{n,2}} e^{j8h\pi\gamma_{n,3}} e^{j16h\pi\gamma_{n,4}} b_{0,n-1}^{(0)} b_{0,n-1}^{(1)} b_{0,n-1}^{(2)} b_{0,n-1}^{(3)} b_{0,n-1}^{(4)} \qquad (19)$$

$$a_{2,n} = e^{jh\pi\gamma_{n,0}} e^{j4h\pi\gamma_{n,2}} e^{j8h\pi\gamma_{n,3}} e^{j16h\pi\gamma_{n,4}} b_{0,n-1}^{(0)} b_{0,n-1}^{(1)} b_{0,n-1}^{(2)} b_{0,n-1}^{(3)} b_{0,n-1}^{(4)}$$

and the state vector of the <u>uncoded</u> 32-GFSK signal is given by

$$\theta_{n-1} \approx b_{0,n-1}^{(0)} b_{0,n-1}^{(1)} b_{0,n-1}^{(2)} b_{0,n-1}^{(3)} b_{0,n-1}^{(4)}$$

$$= \exp\left\{ jh\pi \sum_{m=0}^{n-1} (16\gamma_{m,4} + 8\gamma_{m,3} + 4\gamma_{m,2} + 2\gamma_{m,1} + \gamma_{m,0}) \right\}$$

$$= \exp\left\{ jh\pi \sum_{m=0}^{n-1} \alpha_m \right\}$$

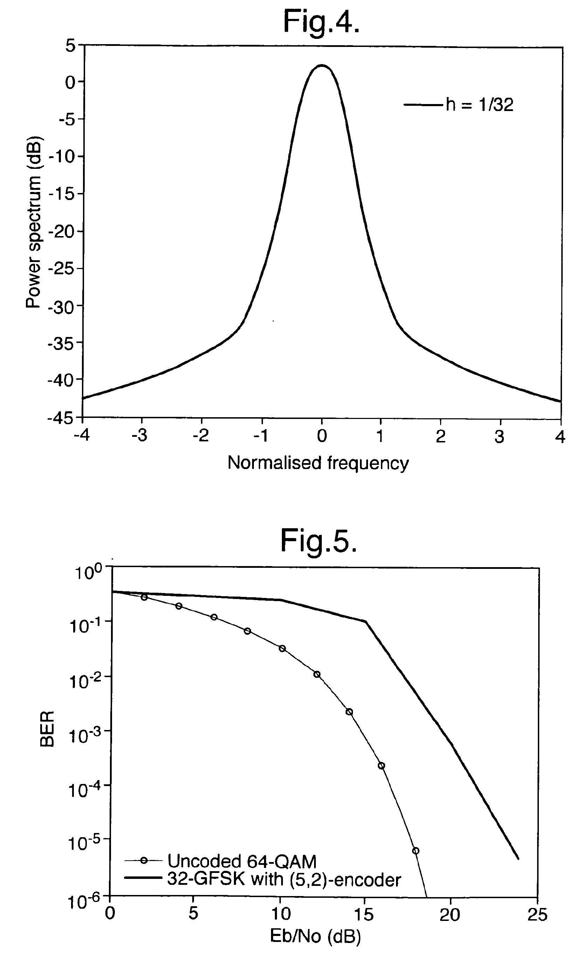

A simulated spectrum with a normalised symbol rate of 1 per second is shown in figure 4. The -3dB occupied bandwidth is around 0.7Hz. As the symbol contains 4 user bits, the bandwidth efficiency is 4/0.7 or nearly 6 bits/s/Hz, which is comparable with 64QAM (= 6bits/s/Hz), When scaled to STM4 (620Mbit/s), the symbol rate is 155Mbaud and the bandwidth would be just over 100MHz. This is in contrast with the state-of-the-art maximum data rate over satellite links which is 155Mbit/s in 72MHz bandwidth, where amplifiers are operated in the linear region.

On links which are not already power limited, the power may be increased due to the constant-envelope nature of the M-GFSK signal, which in many cases will more than compensate for the difference in performance to 64-QAM.

1. Laurent filtering/decomposition

The output of the Laurent filters is

$$r_{k,n} \square \int_{-\infty}^{\infty} r(t) g_k(t-nT) dt = r(t) \otimes g_k(-t)\big|_{t=nT} \qquad (24)$$

(here, the [] symbol indicates a = symbol)

2. Viterbi algorithm

ML detection theory, refer to appendix for more detail

A coherent ML detector selects the information sequence according to

$$\hat{\boldsymbol{\alpha}} = \arg\max_{\tilde{\boldsymbol{\alpha}}} \lambda(\tilde{\boldsymbol{\alpha}}) \qquad (25)$$

where

$$\lambda(\tilde{\boldsymbol{\alpha}}) = \mathrm{Re}\left\{ \sum_n \sum_{k=0}^{N-1} \tilde{a}_{k,n}^* \int_{-\infty}^{\infty} r(t) g_k(t-nT) dt \right\}$$
$$= \mathrm{Re}\left\{ \sum_n \sum_{k=0}^{N-1} \tilde{a}_{k,n}^* r_{k,n} \right\} \qquad (26)$$

Equation (26) is used to calculate the path metrics, where the paths represent the transmitted symbols in the usual way.

The pseudo-symbols $\alpha_{k,n}$ can be decomposed into $\theta_{n-1}$ representing the current phase state and a manipulation of the incoming information symbol, e.g.

$$a_{0,n} = (e^{jh\pi\gamma_{n,0}} e^{j2h\pi\gamma_{n,1}} e^{j4h\pi\gamma_{n,2}} e^{j8h\pi\gamma_{n,3}} e^{j16h\pi\gamma_{n,4}}) \cdot \theta_{n-1} \qquad (27)$$

An M-ary continuous phase modulation scheme is represented by over-laying multiple binary schemes according to [3]. The decomposition of the M = 32 information symbols $\alpha_i \in \{\pm 1, \pm 3, ..., \pm 31\}$ into five binary bits $\gamma_{i,l} \in \{\pm 1\}$, $0 \leq l \leq 4$ is

$$\alpha_i = 16\gamma_{i,4} + 8\gamma_{i,3} + 4\gamma_{i,2} + 2\gamma_{i,1} + \gamma_{i,0} \qquad (28)$$

The incoming information symbols not only change the phase state of M-GFSK, but also the state of the convolutional encoder.

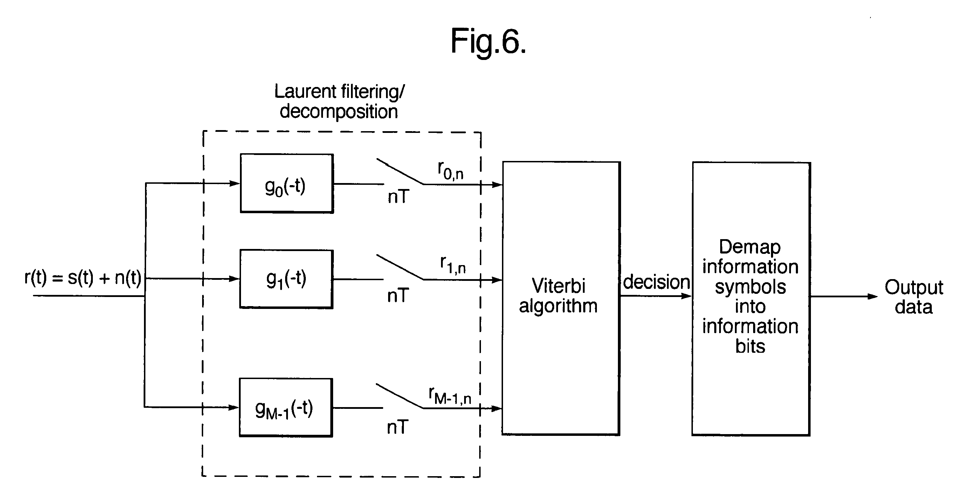

The trellis diagram of Viterbi algorithm is given in Figure 6. The decoder then calculates the branch metrics

$$\lambda(\tilde{\boldsymbol{a}}) = \mathrm{Re}\left\{ \sum_n \sum_{k=0}^{N-1} \tilde{a}_{k,n}^* \int_{-\infty}^{\infty} r(t)g_k(t - nT)dt \right\}$$
$$= \mathrm{Re}\left\{ \sum_n \sum_{k=0}^{N-1} \tilde{a}_{k,n}^* r_{k,n} \right\} \qquad (29)$$

and uses them to update the survivor path metrics in the trellis. The decoder then selects the path with maximum metric. The Information symbols associated with the survivor path are generated, and then are demapped into original input bits.

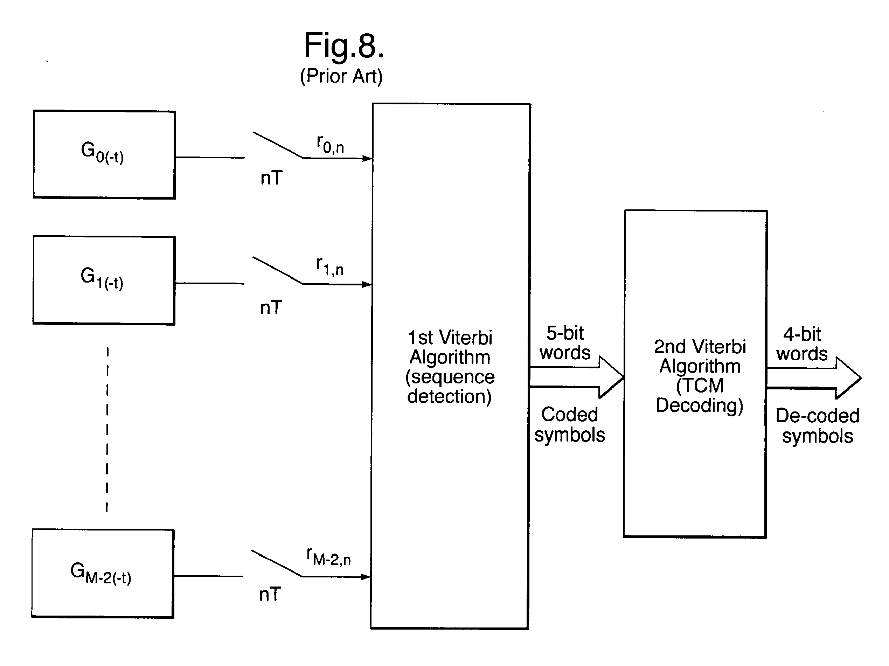

In order to understand the invention, is helpful to first consider a prior art demodulator and decoding process as shown in Fig 8. Here, a bank of Laurent filters (each filter denoted by the G(t)) receives a continuous phase modulated signal. The filters each provide an output (an amplitude signal) which is sampled at intervals corresponding to the symbol period. On the basis of these outputs, a first Viterbi stage running a Viterbi algorithm (or other Maximum Likelihood "ML" algorithm) detects the symbols, and provides a word sequence which is representative of the encoding, if any, imposed on the received signal. Thus, if the prior art demodulator were to receive the encoded signal of the present system, the Viterbi stage would provide a signal that is representative of a five bit word. A second Viterbi stage is therefore needed to convert the encoded five bit word into the decoded four bit word, and remove the redundancy introduced by the encoding.

It is helpful to understand how the signal from the transmitter 1 would be decoded were a second Viterbi stage to be employed as shown in Fig 8.

Referring to the states of the delay stages D1,D2 of Fig 2a, these can each be in a state 0 or 1. Fig 2b is a "trellis" state diagram showing each possible state for D1,D2, the two memory blocks in the coder, which are 00, 01, 10 and 11. The first column of four dots represents the state at one time, the second column represents the state at a later time, in this case 1 bit period later. The lines joining the dots, referred to as path lines, indicate the change from a state at time t to a state at time t+(bit period). The two bit word next to each line is the output from the encoder when the state of the encoder changes as indicated by that line.

As bits arrive at the coder, the memory blocks may or may not change state, depending whether the incoming bit to a block is the same as the bit already at that block. The coder will start in the state 00. If a '1' is applied at the input, the state of the first memory block will change to a '1' and so will the upper of the two outputs from the coder via the action of the XOR gate, but the other out put will remain at '0'. So two things have happened on application of the '1': the memory blocks have changed state from 00 to 10; and, the output has changed from 00 to 10. The fact that the memory blocks have changed state is indicated in the trellis state diagram by the fact that a path line is drawn on the trellis from state 00 to state 10. If a '0' had been applied then the state would have remained at 00. So, in the trellis state diagram, lines leaving the state represent whether a '1' or '0' has been applied at the input by turning 'right' or 'left' (upwards or downwards in the orientation of Fig 2b) from that state respectively (as indicated beneath the trellis). The output from the coder, which is '10' for application of a '1' and '00' for application of a '0', is written next to the path line between states. If a '1' is entered, followed by a string of zeros to the above encoder, the output will be the pattern 10010100000... This is the impulse response of the coder and it lasts for 6 bits at the output, i.e. the input bit affects the output for the following 6 bits or 3 2-bit words.

The coder in practice could have more memory bocks. If there were more memory blocks then the impulse response would be longer. This is known as the memory span or 'constraint length' of the encoder. The way this code is described is by the polynomials: the outputs are gathered from the coder at $1 + x^3$ for the upper one and $x^2$ for the lower one, with binary patterns 101, 010 or (5,2) expressed in octal.

The following explains the decoding process that the second Viterbi stage would carry out. A decoder will normally be provided that is complementary to the coder: that is, the will know the details of encoder trellis state diagram of Fig 2b. Supposing the encoder starts at state 00, then the receiver knows that the only two valid outputs from the coder leaving this state are 00 and 10, where the 00 path indicates that a '0' has been encoded and the 10 indicates that a '1' has been encoded. If 00 is received it can be inferred that the a 0 was sent, whereas if a 10 is received, it can be inferred that a 1 was sent. Thus from the received encoded two bit words, the transmitted data can in principle be retrieved. If anything else is received, such as 11 (because of inter symbol interference or other noise or errors during transmission), then the receiver knows there has been an error. What the receiver will do in this case is to assume both paths are valid, but will put weightings or 'metrics' on the two paths. A common way of calculating the metric by comparing the received invalid code-word (11) with the two valid ones (00 and 10) and calculated the Hamming distance between them, i.e. the number of places where they differ. Comparing 11 with 00, the metric = 2 because the words are different in 2 places, whereas for 01 the metric = 1. What has happened is the path has split into two. The receiver carries on the decoding process, keeping two or perhaps more paths alive until a number of words received has exceeded the constraint length of the code. At this point, the receiver will discard the path that has the highest summation of metrics and the path that is left is called the 'survivor' path, which is the 'most likely' sequence that was transmitted. Hence this type of decoder is called maximum likelihood (ML).

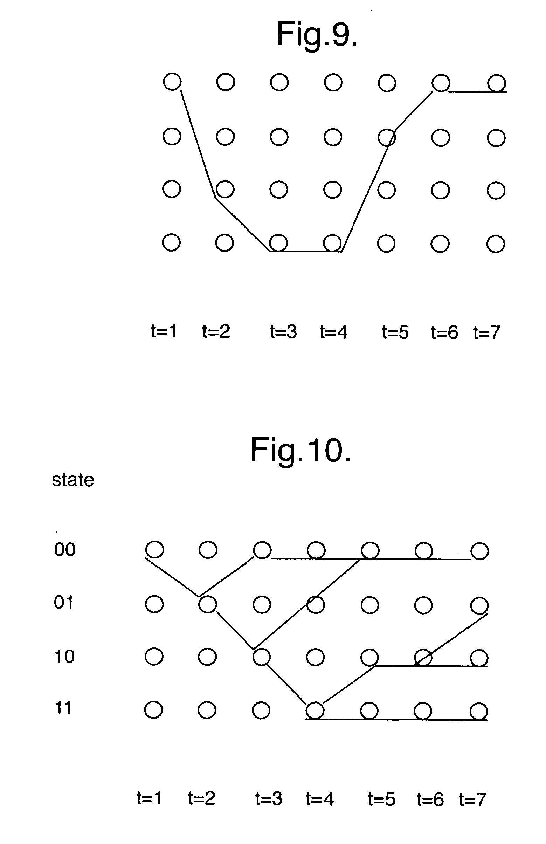

The states of the coder at different times can be represented on a trellis diagram as indicated in Fig 9 (time is shown in units of 1 bit period). This shows the states at successive times t=1 to t=7. For example, the starting state is 00, then the coder moves to 10 (10 received); then to 11 (11 received); then stays at 11 (11 received); then moves to 01 (11 received) act.. In this situation, no errors occurred. The decoder can infer the transmitted bits from the information in the trellis state diagram of F. That is, the path of Fig 9, which represents a set of received two bit words, can be used to unambiguously infer the pre-encoded bits.

To understand how the decoder can operate in the presence of transmission errors, it is helpful to consider the situation shown in Fig 10. Here, at t=2 the decoder has received a two bit word from the encoder which, on the basis of the trellis state diagram, the encoder knows cannot have been transmitted (e.g., 11 is received when, originating from the trellis state 01, only 10 or 00 can be received). In such a situation, where the encoder receives an impermissible word, the encoder is configured to construct two possible paths on the basis of the permissible words which the decoder knows can correctly be received. That is, the decoder assumes that encoder has in fact transmitted a 10 or a 00, and constructs two branches accordingly between t=2 and t=3. Further branches are created in this way each time an impermissible word is received, as shown in Fig 10. Each path segment of a bit-period duration has associated therewith a metric at least partly indicative of the assumed likelihood of that segment being correct. This metric calculated as a function of the hamming distance (i.e., the extent of the difference) between the received word giving rise to a path segment and the actual word received.

Clearly, where a permissible word is received, the hamming distance is zero, and the word is assumed to have been correctly received. The branching path structure shown in Fig 10 is viewed as a plurality of partially overlapping paths, and the metric associated with each path are summed. The path with the smallest metric will be assumed to be the correct one. From this path, termed the survivor path, the pre-encoded bits are inferred. At intervals, the metric summation will be re-set, the number of bits over which the metrics are summed being dependent on the encoder as well as other parameters.

The path diagram of Fig 10 is merely a convenient way to conceptualise the operation of the decoder, which will operate an algorithm known as a Viterbi algorithm on a processor (such decoders are known as Viterbi decoders). Clearly, the algorithm will operate according to a set of rules from which a set of permissible words can be derived (which rules can be represented by the trellis state diagram of Fig 2b and are based on the known characteristics of the coder). The algorithm will map received words to permissible words in accordance with said rules, (as represented by the trellis diagram of Fig 10), each mapped word being stored in memory in association with a respective metric, each metric associated with a mapped word being calculated in dependence on a measure of the difference between the mapped word and the received word from which it is mapped. The set of permissive words will depend on the history of previously received words, and will normally change as successive words are received.

Thus, in one type of Viterbi process, the following steps are carried out (not necessarily exact numerical order):

    1. assume starting state (here 00)
    2. receive word from encoder
    3. on the basis of the starting state, determine set of permissible words

4. decide whether received word is permissible;

5a. if received word is permissible (i.e., a member of the above determined permissible set), infer and record state of coder from state diagram (Fig 2b) and go to 6

5b. if received word is not permissible (i.e., not a member of the above determined permissible set), record possible states of coder from state diagram (i.e., associate a coder state with each member of the permissible word set, the associated coder state being the state the coder would have been in had that permissible word been received)

6. associate a path metric with the or each state recorded at step 5a or 5b, each metric having a layer associated therewith (i.e., m= m(layer_number, path_number)), so you have m(0,1), m(0,2), m(0,3)

7. treat the or each state recorded at step 5a or 5b as an assumed starting state at step 1 and repeat steps 2-6, and increment the layer number each time steps 2-6 are completed

8. after a number of cycles of steps 2-6, calculate the sum of path metrics m(0,p)m(1,p)m(2,p) etc for each combination of the p values, and assume the lowest sum value corresponds to correct path, and infer the word values that are correct

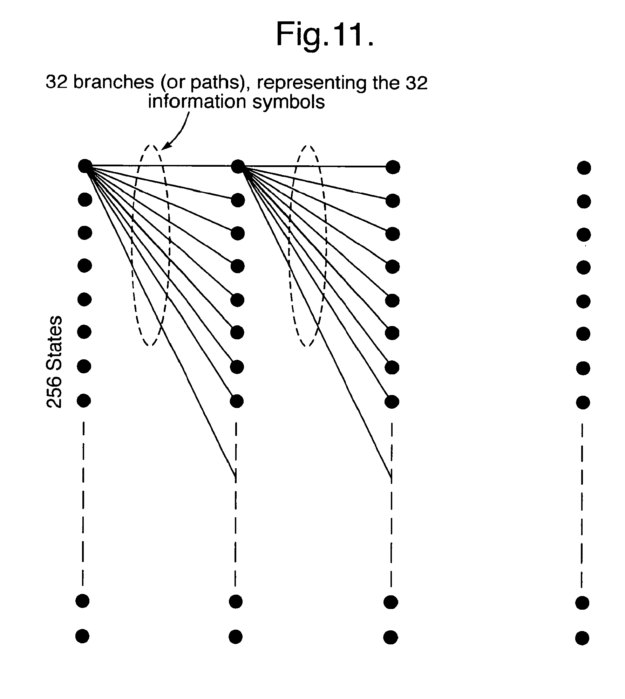

The first Viterbi stage functions in a similar way to the decoder described above. The Viterbi stage assigns a probability value or metric to each of a set of pseudo symbols as described with reference to eqn 26 above. As a result, a metric is provided in association with each of the M information symbols (here, there as N=M-1 filters as only the principle ones are being used). A trellis can be constructed in a similar fashion to that of Figs 9 and 10, except that now, each state can be mapped to 32 next states, as indicated in Fig 11. A metric is assigned to each branch, and the most likely path is chosen according to the Viterbi principle.

In one embodiment of the present invention the function of the second viterbi stage of Fig 8 is included in the Viterbi process of the first viterbi stage: that is, the sequence detection and decoding are performed together (i.e., at the same time). In order to do this, knowledge of the coding characteristics (that is, the correlation of the encoded bits) is used to reduce the number of possible allowed transitions (branches) in the trellis diagram of Fig 11 from 32 to only 16. This is done by setting 16 of the transitions to be impermissible (that is, making the metric for that branch zero), based on the information in the trellis state diagram of Fig 2b. Thus, the redundancy in the signal is removed when choosing the metrics, rather than after the metrics have been used to detect the sequence. Therefore the paths in the combined detection and decoding trellis can be denoted as

$$\sigma'_n = (\theta_{n-1}, s_{n-1}, s_{n-2}, \ldots, s_{n-\nu+1}, \alpha_n)$$

where the $\theta_{n-1}$ is the number of phase states available from simplified LC process (=64), the $s_n$'s are the encoder states = 4 (for the 5,2 code) and the $\alpha$ is the set of user (ie pre-coded) information symbols = 16. Thus there are 64 * 4 * 16 = 4096 different paths possible in the trellis, which divided among the 256 states is 16 paths per state, each representing a pre-coded symbol.

The final step in the receiver process is to de-map the symbols to bits.

The following explains how the information in the redundancy in the signal (introduced by the encoder in Fig 2a), in particular with reference to information in Fig 2b (of which the receiver has knowledge), can be used to reduce the number of possible paths by eliminating certain paths.

EXAMPLE

At the transmitter, the trellis encoder codes as follows:

Input stream
000100011101110011100100010000111101011 (random-ish)

This is split into 4 bit words
0001 0001 1101 1100 1110 0100 0100 0011 1100 1011

The LSBs are the right-hand bits as follows
1110000101

Assuming starting state and output state = 00, the ½ rate coder turns these into
10 11 01 11 10 00 00 10 01 00

making up the 5 bit words
00010 00011 11001 11011 11110 01000 01000 00110 11001 10100

which are mapped to the 31 symbols
2, 3, 25, 27, 30, 8, 8, 6, 25, 20

At the receiver, there is a 256-state trellis, as discussed. The 256 states originate from the fact that we have a modulation index of 1/32 that causes 64 states to be available from the uncoded modulation, multiplied by 4 that represents the encoder states, to make a total of 256.

From each state, we could draw 32 branches, as illustrated in figure 11. Each of the branches or paths would has a metric associated with it that is calculated using every one of the LD filter outputs.

NOW, each branch represents a symbol that is transmitted, one of 32, made up from the 5-bit words from the encoder. BUT each one of these is composed by taking a 4-bit word from the user and applying a code. The code above and its separate trellis is shown next.

From state 00, if symbol 2 is sent, 00010, the encoder follows the path 10 to state 10 (see above). From state 10, only the symbols ending with 01 and 11 are possible, ie 1, 3, 5, 7, 9, 11, the odd ones, up to 31.

Now, the trellis at the output of the receiver knows this, ie symbol 2 can only be followed by an odd symbol and likewise every symbol can only be followed by an odd or an even one, because of the presence of the code. Therefore only 16 branches are necessary so that only 16 metrics need to be calculated, but they are a different 16 depending on the previous symbols. From the resulting 16 branches from each of the 256 states in the output trellis, the user information symbols can be generated.

Clearly, the various stages in each of the transmitter and the receiver are implemented in one or more processors that have access to one or more memory locations for storing data.

The following additional comments are provided:

The above description relates to a modulation system suitable for radio links, especially the line-of-sight ones that are employed on satellite and terrestrial microwave systems. Satellite communications and microwave links have been a very important part of the global telecommunications systems for the past four decades and are often used when it is not commercially or technically feasible to lay fibre-optic cable. There are many situations where fibre is not feasible - for example when it is necessary to cross water or mountainous regions. Also, some 38 countries still rely upon satellite links for their international voice and data communications. Even when in competition with fibre, satellite operators have made commercial success of providing backhaul to connect Internet Services Providers (ISPs) from eastern Europe and the middle / far east, with western Europe and the US, especially when the traffic requirements are asymmetric. Given the high capital cost of satellite systems and microwave links, there is significant incentive for service providers to use them very efficiently.

Increasingly, radio spectrum is becoming a scarce resource so that there is real pressure to improve spectral efficiency of radio systems. There is continuing effort in the modem industry to provide higher throughput over satellite and microwave links in order to lower the transmission costs. The state of the art in satellite links allows transmission of approximately 155Mbit/s (STM-1) over satellite links and 622Mbit/s (STM-4) over microwave links using dual polarised channels.

Attempts to improve the spectral efficiency commonly involve the use of higher order QAM (Quadrature Amplitude Modulation). One difficulty with the QAM schemes is that, in any practical link (i.e. one in which the bandwidth is limited), the modulated signal envelope is not constant, for instance filtered OQPSK has an envelope variation of 33%. This means that amplifiers and frequency converters in the transmitter and receiver chains have to be operated in a linear region to faithfully reproduce the envelope variations. If allowed to operate too near their maximum output power, these devices will tend to 'limit' the signal envelope, hence increasing the occupied bandwidth of the signal and its potential to cause interference. Having to operate the amplifiers and frequency converters in the linear region makes them inefficient because they have to be backed off significantly from their maximum possible (i.e. saturated) output power. Various linearisation techniques are commonly used to allow amplifiers to run closer to the saturated power while handling QAM signals without distortion, but these have limited benefit.

The above describes an improved demodulation method that allows a continuous phase modulation (CPM) to be used, called M-GFSK (M-ary Gaussian Frequency Shift Keying) although the method could also be applied to other CPM schemes. M-GFSK was specifically designed for satellite and microwave links, but will also find applications where low power consumption is important, e.g. in portable devices. One feature of this CPM scheme is a constant envelope that allows amplifiers in the transmitter chain to run at saturated power and hence higher power efficiency. The resulting higher output power allows the current state of the art to be exceeded in a large number of cases, i.e. where the link is not already power limited.

The above embodiment can be summarised in the following terms: it to a method of demodulating and decoding a convolutionaly encoded bit stream that has been modulated so as to form a continuous phase modulated signal. The signal is passed through a bank of Laurent filters, the outputs of which are passed to a processor running a Viterbi algorithm for demodulating the signal. The metrics of evaluating the most probable path in the Viterbi algorithm are calculated by including the redundancy in the signal introduced by the convolutional coding. Specifically, certain paths are excluded as impermissible from a knowledge of the encoding. As a result, the path selected by the Viterbi algorithm as being the most probable path corresponds to the data signal without the redundancy. This reduces or removes the need for a second Viterbi algorithm to remove the redundancy in the signal and reduces the processing required.

Appendix 1

Decoding theory

Performing Laurent decomposition, the complex envelope of the M-GFSK signal can be exactly expressed as

$$s(t, \boldsymbol{\alpha}) = \sqrt{\frac{E_s}{T}} \sum_{k=0}^{N-1} \sum_n a_{k,n} g_k(t - nT) \tag{1}$$

where $N = M^{L-1} (M\text{-}1)$. The key parameters in equation (4) are the so-called Laurent functions (LF's) $g_k(t)$ and the pseudo-symbols $\alpha_{k,n}$.
The complex-baseband received signal to be processed by a coherent detector is

$$r(t) = s(t, \boldsymbol{\alpha}) + n(t) \tag{2}$$

where $n(t)$ is the complex AWGN process with one-sided power spectral density $N_0$.
The detector selects the output sequence which minimizes the Euclidean distance

$$\lambda(\tilde{\boldsymbol{\alpha}}) = \int_{-\infty}^{\infty} \left| r(t) - s(t, \tilde{\boldsymbol{\alpha}}) \right|^2 dt \tag{3}$$

Minimizing (3) is equivalent to maximizing the correlation function

$$\lambda(\tilde{\boldsymbol{\alpha}}) = \text{Re} \int_{-\infty}^{\infty} r(t) s^*(t, \tilde{\boldsymbol{\alpha}}) dt \tag{4}$$

Inserting the Laurent decomposition of (1) into (4) we got

$$\lambda(\tilde{\boldsymbol{\alpha}}) = \text{Re}\left\{ \sum_n \sum_{k=0}^{N-1} \tilde{a}_{k,n}^* \int_{-\infty}^{\infty} r(t) g_k(t - nT) dt \right\}$$
$$= \text{Re}\left\{ \sum_n \sum_{k=0}^{N-1} \tilde{a}_{k,n}^* r_{k,n} \right\} \tag{5}$$

where $r_{k,n}$ is the output of the matched filters, and denoted as

$$r_{k,n} \triangleq \int_{-\infty}^{\infty} r(t) g_k(t - nT) dt = r(t) \otimes g_k(-t) \big|_{t=nT} \tag{6}$$

Therefore, a coherent ML detector selects the information sequence according to

$$\hat{\boldsymbol{\alpha}} = \arg \max_{\tilde{\boldsymbol{\alpha}}} \lambda(\tilde{\boldsymbol{\alpha}}) \qquad (6)$$

Appendix 2

References

[1] P. A. Laurent, "Exact and approximate construction of digital phase modulations by superposition of amplitude modulated pulses (AMP)," IEEE Trans. Commun., vol. COM-34, pp. 150-160, Feb. 1986.
[2] S. V. Pizzi and S. G. Wilson, "Convolutional coding combined with continuous phase modulation," IEEE Trans. Commun., vol. COM-33, pp. 20-29, Jan. 1985.
[3] U. Mengali and M. Morelli, "Decomposition of M-ary CPM signals into PAM waveforms," IEEE Trans. Inform. Theory, vol. IT-41, pp. 1265-1275, Sep. 1995.

*Appendix 3*

# Trellis-Coded Multi-Level Gaussian FSK

Michael Fitch, BT Group and Yu Deng, University of York

## 1 Introduction

Gaussian Frequency Shift Keying (GFSK) is a constant amplitude modulation scheme that allows transmitter amplifiers to run in saturation without spectral side-lobe growth, allowing high power efficiency and longer battery life. The Global System for Mobile communications (GSM) air interface uses a binary form of GFSK for this reason, using just two levels. Extending the scheme to $M$ levels leads to higher spectral efficiency but also to greater complexity in the receiver for coherent detection. This paper describes a reduced complexity coherent receiver for trellis-coded (TCM) $M$-GFSK, using a simplified Laurent detector followed by a Viterbi alogorithm that jointly provides maximum likelihood (ML) sequence detection and decoding of the TCM.

The scheme will find uses where power is limited, such as with satellite links and / or small user terminals.

Specifically we describe:
* An $M$-ary TCM GFSK system with a spectral efficiency of 6 bits/s/Hz (equivalent to uncoded 64-QAM). The bit-error ratio (BER) performance in AWGN is slightly worse than 64-QAM, but the additional power that can be supplied through the ability to run transmitters in saturation will more than compensate for this in a large number of cases,
* Use of Laurent decomposition (LD) to represent the GFSK signal as a sum of linear pulse amplitude modulation (PAM) waveforms. We use only the principal Laurent Components (LCs). The number of receiver filters and trellis states used in the Viterbi algorithm is reduced significantly from over 1 million each in the optimal demodulation and decoding case, to 7 filters and 256 states for the simplified scheme with little penalty,
* A joint demodulation and decoding algorithm to achieve a good trade-off between performance and receiver complexity. Other separated demodulation and decoding schemes involve larger receiver complexity and delay but small performance improvement for $M>16$.

Following the introduction, Section 2 describes the generation and states of the $M$-GFSK signal, Section 3 describes the demodulation and decoding process and gives results of BER performance. Section 4 draws some conclusions and gives suggestions for further work.

## 2 Trellis-coded $M$-GFSK signal description

### 2.1 Generation of Trellis-coded $M$-GFSK
Please refer to Fig. 1.

**Fig. 1. Generation of Trellis-coded $M$-GFSK**

The input bits are distributed into 4-bit words, then the least significant bit (LSB) from each word is applied to a ½ rate convolutional encoder. The encoder works with the mapper to obtain a trellis-coded modulation (TCM) to correct errors due to noise and to render insignificant the error floor that is introduced by the simplified Laurent detection process. This is a *pragmatic* TCM implementation where only the LSBs of the transmitted symbols are coded, while the remainder are uncoded. When the detector is perturbed by channel impairments (such as noise) and makes a mistake, it is much more likely to choose a symbol that is adjacent to the correct one than it is to choose one further away. In the symbol mapping, adjacent symbols typically differ only in the LSB so the majority of errors caused by channel impairments are corrected by this coding scheme. Figure 2 shows the (5,2) coding scheme considered in this paper.

**Fig. 2. The (5,2) convolutional code**

Also tried were (15,2) and (33,4) codes which give approximately 1dB and 2dB improvement in AWGN over the (5,2) code respectively for BER = $10^{-6}$.

The bits from the encoder are mapped to $M$ symbols using natural binary mapping, having values symmetrically about zero. The symbols are then multiplied by a unit impulse at the symbol rate in order to properly excite the Gaussian filter which has the frequency response

$$f(t) = \frac{1}{2T}\left\{ erfc\left(2\pi B\frac{t-T/2}{\sqrt{\ln 2}}\right) - erfc\left(2\pi B\frac{t+T/2}{\sqrt{\ln 2}}\right)\right\}$$

(1)

where $B$ is the -3dB bandwidth of the filter and $T$ is the symbol period.

The product $BT$ is defined as the *normalised bandwidth*. As $BT \rightarrow \infty$, the filter output closely resembles the impulse input but, as $BT$ is reduced, the output becomes smoother and is spread more in time, i.e. over adjacent symbols. Furthermore, it has been shown that the performance of the simplified Laurent detector degrades as $BT$ decreases. $BT$ is set to 0.5 with this implementation to give a good trade-off between improved spectral efficiency and Laurent detector performance and less Inter-Symbol Interference (ISI).

The phase response of the filter is the integral of the frequency response, i.e.

$$q(t) = \int_{-\infty}^{t} f(\tau)d\tau \qquad (2)$$

The pulse $f(t)$ from (1) is time limited to the interval $(0, LT)$ and satisfies the following two conditions:

$$f(t) = f(LT - t) \qquad (3)$$

$$\int_{-\infty}^{LT} f(\tau)d\tau = q(LT) = 1/2 \qquad (4)$$

These two conditions effectively truncate the response from the filter to be $L$ symbol periods. As the ISI is not significant at more than 2 symbols away with $BT = 0.5$, we have put $L = 4$ (i.e. +/- $2T$ from the centre of the current symbol).

The final stage in the modulation process is to translate the output from the Gaussian filter to the carrier frequency using a voltage-controlled oscillator. The complex envelope of the resulting $M$-GFSK signal has the form

$$s(t,\alpha) = \sqrt{\frac{E_s}{T}}\exp(j\theta(t,\alpha)) \qquad (5)$$

with

$$\theta(t,\alpha) = 2\pi h \sum_{k=-\infty}^{n} \alpha_k q(t-kT), \quad nT \le t \le (n+1)T \qquad (6)$$

where $\theta(t,\alpha)$ is the *carrier phase*, $E_s$ is the symbol energy, $T$ is the symbol interval, $\alpha = \{\alpha_k\}$ is the sequence of $M$-ary symbols to be modulated with possible values $\{\pm 1, \pm 3, \ldots, \pm(M-1)\}$, $h = m/p$ is the modulation index ($m$ and $p$ are relatively prime integers), and $q(t)$ is the *phase response* of the system which, as stated earlier, is the integral of a frequency pulse set to be Gaussian. In our implementation we have set $M = 32$ and $h = 1/32$.

Equation (5) shows that the signal is in fact a continuous phase modulation (CPM) with constant envelope $\sqrt{E_s/T}$.

### 2.2 Uncoded and coded M-GFSK signal states

The *carrier phase* $\theta(t,\alpha)$ in (5) can be rewritten as

$$\theta(t,\alpha) = \pi h \sum_{k=-\infty}^{n-L} \alpha_k + 2\pi h \sum_{k=n-L+1}^{n} \alpha_k q(t-kT) \qquad (7)$$
$$= \theta_{n-L} + \phi(t,\alpha), \quad nT \le t \le (n+1)T$$

where it is defined that

$$\theta_{n-L} = \pi h \sum_{k=-\infty}^{n-L} \alpha_k \qquad (8)$$

$$\phi(t,\alpha) = 2\pi h \sum_{k=n-L+1}^{n} \alpha_k q(t-kT) \qquad (9)$$

These two equations illustrate that the state of the $M$-GFSK signal at $t = nT$ depends on the combined phase state $\theta_{n-L}$ and the phase contribution of the signal pulses that have not reached their final values $\phi(t,\alpha)$. The phase state of the signal before any coding is applied can be denoted as

$$S_{unc} = (\theta_{n-L}, \alpha_{n-L+1}, \ldots, \alpha_{n-1}) \qquad (10)$$

According to [1], $\theta_{n-L}$ can take on only $p$ states (mod $2\pi$) at every time step, so for the partial response signal of length $LT$ and considering that there are M varieties of $\alpha$, the total number of states is

$$N_s = pM^{L-1} \qquad (11)$$

Now considering the addition of the trellis code, according to [1] the state of the coded M-GFSK signal at $t = nT$ can be expressed as the combination of the phase state of uncoded GFSK, $S_{unc}$, and the state of the convolutional code $S_{conv}$

$$S_{enc} = (S_{unc}, S_{conv}) \qquad (12)$$

and

$$S_{conv} = (s_{n-1}, s_{n-2}, \ldots, s_{n-v+1}) \qquad (13)$$

where $v$ is the constraint length of the code.

For the partial response signal of length $LT$ the total number of states is

$$N_s = p2^{v-1+\mu(L-1)} \qquad (14)$$

where $p$ is the denominator of the modulation index $h$, $v$ is the constraint length of the code with code rate $r = \mu/\eta$ and $L$ is the symbol duration of the signal pulse.

For our implementation using a (5,2) code, $v = 3$, $\mu = 4$ and $N_s$ is 524288.

## 3 Receiver

### 3.1 Laurent decomposition

The structure of the simplified detector is shown in Figure 3. The receiver consists of a bank of $M - 1$ Laurent filters, followed by a Viterbi Algorithm (VA) performing Maximum Likelihood Sequence Estimation (MLSE) to mitigate ISI. The information symbols at the output of the Viterbi algorithm are then demapped into information bits.

Fig. 3. Structure of the simplified detector for M-ary GFSK

We briefly review the LD here, readers should refer to [2] for more detail. Performing LD, the complex envelope of the M-GFSK signal can be exactly expressed as

$$s(t,\alpha) = \sqrt{\frac{E_s}{T}} \sum_{k=0}^{N-1} \sum_n a_{k,n} g_k(t-nT) \qquad (15)$$

where $N = M^{L-1}(M-1)$. The key parameters in equation (15) are the so-called Laurent functions (LF's) $g_k(t)$ and the pseudo-symbols $a_{k,n}$.

For $M = 32$ and $L = 4$, $N = 1015808$ for the exact decomposition, but as shown in [3], most of the signal energy is concentrated in the first $(M-1)$ components which are referred to as the *principal* LCs. In this implementation, only the principal LCs are used for simplification.

Fig. 4 shows the shapes of the decomposed PAM waveforms of the principal LCs for 32-GFSK of $h = 1/32$ and $BT = 0.5$. Note that the higher functions contain much less energy than the first function $g_0$. There are 30 plots in the higher functions, but it can be seen that many of them are so close together, that fewer filters can be used with insignficant degradation in performance. In fact, in the implementation that we tried, only 7 filters are used.

Fig. 4. Shapes of the decomposed PAM waveforms with principal LCs for 32-GFSK

### 3.2 ML detection theory

The complex baseband received signal to be processed by a coherent detector is

$$r(t) = s(t,\alpha) + n(t) \qquad (16)$$

where $n(t)$ is the complex AWGN process with one-sided power spectral density $N_0$.

The detector selects the output sequence which minimizes the Euclidean distance

$$\lambda(\tilde{\alpha}) = \int_{-\infty}^{\infty} |r(t) - s(t,\tilde{\alpha})|^2 \, dt \qquad (17)$$

Minimizing (17) is equivalent to maximizing the correlation function

$$\lambda(\tilde{\alpha}) = \text{Re} \int_{-\infty}^{\infty} r(t)s^*(t,\tilde{\alpha})dt \qquad (18)$$

Inserting (15) into (18) yields

$$\lambda(\tilde{\alpha}) = \text{Re}\left\{ \sum_n \sum_{k=0}^{N-1} \tilde{a}_{k,n}^* \int_{-\infty}^{\infty} r(t)g_k(t-nT)dt \right\}$$
$$= \text{Re}\left\{ \sum_n \sum_{k=0}^{N-1} \tilde{a}_{k,n}^* r_{k,n} \right\} \qquad (19)$$

where $r_{k,n}$ is the output of the matched filters, and denoted as

$$r_{k,n} \approx \int_{-\infty}^{\infty} r(t)g_k(t-nT)dt = r(t) \otimes g_k(-t)|_{t=nT} \quad (20)$$

Therefore, a coherent ML detector selects the information sequence according to

$$\hat{\alpha} = \arg\max_{\tilde{\alpha}} \lambda(\tilde{\alpha}) \qquad (21)$$

Equation (19) are the path metrics, each metric is calculated using every filter output and all possible information symbols with the paths representing the transmitted symbols.

### 3.3 Joint demodulation and decoding

As an example, for 32-GFSK the pseudo-symbols $a_{k,n}$ of the first three Laurent components is (developed from [3])

$$a_{0,n} = b_{0,n}^{(0)} b_{0,n}^{(1)} b_{0,n}^{(2)} b_{0,n}^{(3)} b_{0,n}^{(4)}$$

$$a_{1,n} = b_{0,n-1}^{(0)} b_{0,n}^{(1)} b_{0,n}^{(2)} b_{0,n}^{(3)} b_{0,n}^{(4)} \tag{22}$$

$$a_{2,n} = b_{0,n}^{(0)} b_{0,n-1}^{(1)} b_{0,n}^{(2)} b_{0,n}^{(3)} b_{0,n}^{(4)}$$

To calculate the $b$'s (refer to [3]):

$$b_{0,n}^{(0)} = \exp\left\{ jh\pi \sum_{m=0}^{n} \gamma_{m,0} \right\} = b_{0,n-1}^{(0)} e^{jh\pi\gamma_{n,0}}$$

$$b_{0,n}^{(1)} = \exp\left\{ j2h\pi \sum_{m=0}^{n} \gamma_{m,1} \right\} = b_{0,n-1}^{(1)} e^{j2h\pi\gamma_{n,1}}$$

$$b_{0,n}^{(2)} = \exp\left\{ j4h\pi \sum_{m=0}^{n} \gamma_{m,2} \right\} = b_{0,n-1}^{(2)} e^{j4h\pi\gamma_{n,2}} \tag{23}$$

$$b_{0,n}^{(3)} = \exp\left\{ j8h\pi \sum_{m=0}^{n} \gamma_{m,3} \right\} = b_{0,n-1}^{(3)} e^{j8h\pi\gamma_{n,3}}$$

$$b_{0,n}^{(4)} = \exp\left\{ j16h\pi \sum_{m=0}^{n} \gamma_{m,4} \right\} = b_{0,n-1}^{(4)} e^{j16h\pi\gamma_{n,4}}$$

Substituting (23) into (22) we get

$$a_{0,n} = e^{jh\pi(16\gamma_{n,4}+8\gamma_{n,3}+4\gamma_{n,2}+2\gamma_{n,1}+\gamma_{n,0})} \cdot \theta_{n-1}$$

$$a_{1,n} = e^{jh\pi(16\gamma_{n,4}+8\gamma_{n,3}+4\gamma_{n,2}+2\gamma_{n,1})} \cdot \theta_{n-1} \tag{24}$$

$$a_{2,n} = e^{jh\pi(16\gamma_{n,4}+8\gamma_{n,3}+4\gamma_{n,2}+\gamma_{n,0})} \cdot \theta_{n-1}$$

where

$$\theta_{n-1} = b_{0,n-1}^{(0)} b_{0,n-1}^{(1)} b_{0,n-1}^{(2)} b_{0,n-1}^{(3)} b_{0,n-1}^{(4)}$$

$$= \exp\left\{ jh\pi \sum_{m=0}^{n-1} (16\gamma_{m,4} + 8\gamma_{m,3} + 4\gamma_{m,2} + 2\gamma_{m,1} + \gamma_{m,0}) \right\}$$

$$= \exp\left\{ jh\pi \sum_{m=0}^{n-1} \alpha_m \right\} \tag{25}$$

The $\theta_{n-1}$ represents the state vector of the 32-GFSK (ie coded) signal, after the Laurent detector with principal LC filters.

The decomposition of the coded information symbols $\alpha_i \in \{\pm 1, \pm 3, \ldots, \pm 31\}$ into five binary bits $\gamma_{i,l} \in \{\pm 1\}$, $0 \le l \le 4$ is

$$\alpha_i = 16\gamma_{i,4} + 8\gamma_{i,3} + 4\gamma_{i,2} + 2\gamma_{i,1} + \gamma_{i,0} \tag{26}$$

For example, $\alpha_i = -31$ can be decomposed into

$$-31 = 16 \cdot (-1) + 8 \cdot (-1) + 4 \cdot (-1) + 2 \cdot (-1) + (-1)$$

The pseudo-symbols $a_{k,n}$ in (19) can be decomposed into $\theta_{n-1}$ representing the current phase state and the incoming information symbol after manipulation by the code.

Therefore, when representing 32-GFSK with the 31 principal Laurent components, the state vector of the trellis-coded 32-GFSK is the combination of the phase state of uncoded 32-GFSK and the state of the convolutional encoder.

$$\mathbf{S}_n^* = (\theta_{n-1}, s_{n-1}, s_{n-2}) \tag{27}$$

The total number of states is reduced to

$$N_s^* = p2^{v-1} \tag{28}$$

For the considered rate-4/5 (5,2)-encoded 32-GFSK, $p = 32$, $v = 3$ and $N_s^* = 256$.

Each state of the trellis has 16 branches (inputs). Each branch is denoted by

$$\sigma_n^* = (\theta_{n-1}, \alpha_n, s_{n-1}, s_{n-2}) \tag{29}$$

where the $\alpha_n$ are the information symbols and the $s_n$'s describe the state of the encoder.

The incoming information symbols not only change the phase state of $M$-GFSK, but also the state of the convolutional encoder, so we have defined the branches to represent these.

The trellis diagram of Viterbi algorithm is given in Fig. 5. The decoder calculates the branch metrics according to (19), and use it to update the survivor path metrics (the path with maximum metric) in the trellis. The information symbols associated with the survivor path are generated, and then are demapped into original input bits.

**Fig. 5. Trellis diagram of rate 4/5 (5,2) coded 32-GFSK**

Current state:

$$\theta_{n-1} = \exp\left\{ jh\pi \sum_{m=0}^{n-1} \alpha_m \right\} \text{ and the convolutional state}$$

$(s_{n-1}, s_{n-2})$

Next state:

$$\theta_n = \exp\left\{ jh\pi \sum_{m=0}^{n} \alpha_m \right\} \text{ and the convolutional state}$$

$(s_n, s_{n-1})$

So, by using 31 principal LC's a good trade-off between approximation quality and receiver complexity is achieved for this particular $M$-GFSK scheme. Note that at least 32-fold increase in states is required if more LC's are included.

### 3.4 Simulated performance

Computer simulations on BER performance have been done for rate-4/5 Trellis-coded 32-GFSK with different encoders over the AWGN channel. The frame size is set to be 1200 information bits. The *simplified* coherent decoder is applied and it is assumed that ideal channel state information is available within the decoding unit. For all bit error probabilities, 15 frame errors have been used. The memory for the detector is chosen to be 50 channel symbol intervals.

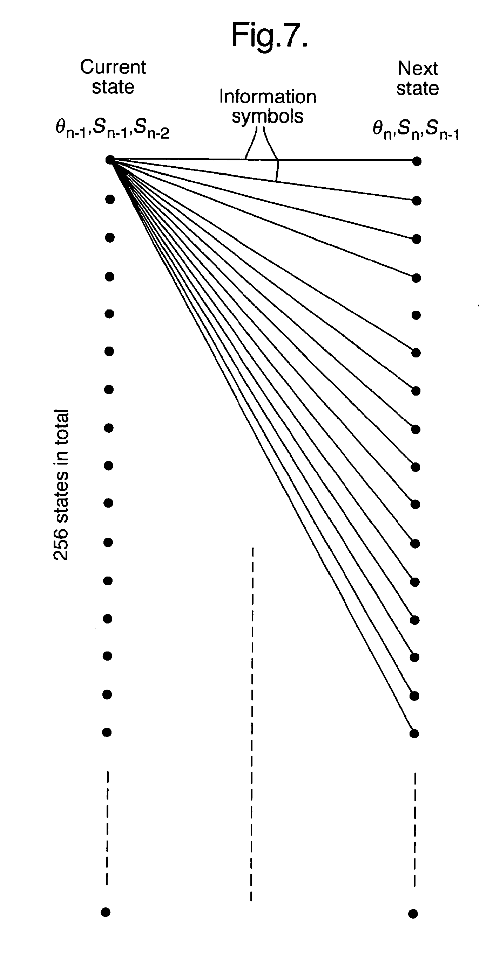

The spectrum of the signal is shown in Fig. 7.

Fig. 7. Spectrum of 32-GFSK signal with $h$ = 1/32.

The 3dB bandwidth of the signal can be seen from figure 5 to be 0.65Hz. This is for $T$ = 1Hz, where each symbol is carrying 4 user bits, giving a spectral efficiency of 4/0.65 = 6.1bits/s/Hz.

Finally, Fig. 8 shows the BER performance of the 32-FSK scheme with (5,2) code compared with uncoded 64 QAM, where it can be seen to be around 5dB worse at BER = $10^{-5}$. The (33,4) code gives a further

2dB improvement and longer codes may improve further.

Fig. 8. BER performance of 32-GFSK with (5,2) trellis code compared with 64 QAM

### 4 Conclusions and further work

In this paper, $M$-GFSK has been described using a trellis code and joint demodulation and decoding. A simplified Laurent detector using the only principal components is described, along with a trellis coding to correct errors caused by noise and to render insignificant the error floor due to the simplified detector. The BER performance is given for a 32-GFSK scheme using (5,2) rate 4/5 code, $h$ = 1/32 and $BT$ = 0.5, which gives a reasonable trade-off between performance and complexity. It is found that the BER performance of this scheme is about 5dB worse than 64 QAM, which is the QAM scheme that has comparable spectral efficiency, reducing to only 3dB worse for the (33,4) code. The worse BER performance is more than compensated by the ability to run transmitter amplifiers at saturation in a large number of cases.

Further work is to assess performance in a multipath channel, to develop symbol timing recovery and test with concatenated coding schemes, hence progressing towards practical modems.

## 5 References:

[1] S.V.Pizzi and S.G. Wilson, "Convolutional coding combined with continuous modulation", IEEE Trans. Commun., vol. COM-33, pp20 – 29, Jan 1985

[2] P. A. Laurent, "Exact and approximate construction of digital phase modulations by superposition of amplitude modulated pulses (AMP)," *IEEE Trans. Commun.*, vol. COM-34, pp. 150-160, Feb. 1986.

[3] U. Mengali and M. Morelli, "Decomposition of M-ary CPM signals into PAM waveforms," *IEEE Trans. Inform. Theory*, vol. IT-41, pp. 1265-1275, Sep. 1995..

**Claims**

1. A method of decoding and demodulating a continuous phase modulated signal formed by a sequence of symbols, the signal having redundancy introduced by an encoding process and intersymbol interference introduced by a modulation process, including the steps of: passing the signal through a filter bank having a plurality of filters; and, performing a maximum likelihood algorithm on the filter outputs to obtain a sequence of symbols with a maximum likelihood associated therewith and thereby demodulating the signal, the maximum likelihood algorithm being such that the encoding is used in the algorithm to remove the redundancy in the signal.

2. A method as claimed in claim 1, wherein the maximum likelihood algorithm has a plurality of possible states associated therewith and the algorithm is configured to record transitions between states in dependence on the received symbols, each transition having a metric associated therewith, and wherein the metrics are calculated in dependence on the information contained in the redundancy of the signal.

3. A method as claimed in claim 2, wherein the encoding is a convolutional coding such that symbols have a correlation, and wherein the metrics are calculated in dependence on the correlation

4. A method as claimed in claim 3, wherein a plurality of transitions are excluded in dependence on the correlation

5. A method as claimed in any preceding claim, wherein the maximum likelihood algorithm is a Viterbi algorithm.

6. A method as claimed in any of the preceding claims, wherein the symbols are each formed from a binary word, and wherein the least significant bit of each word is encoded, the remaining bits remaining uncoded.

7. A method as claimed in any of the preceding claims, wherein each symbol has more than four modulation states

8. A method as claimed in any of the preceding claims, wherein the signal is modulated using a partial response filter having an impulse response that extends over adjacent symbols.

9. A method as claimed in any of the preceding claims, wherein the filter bank is formed by a set of Laurent filters.

10. Demodulating and decoding apparatus for decoding and demodulating a continuous phase modulated signal formed by a sequence of symbols, the signal having redundancy introduced by an encoding process and intersymbol interference introduced by a modulation process, the apparatus having a filter bank with a plurality of filters; and, means for performing a maximum likelihood algorithm on the filter outputs to obtain a sequence of symbols with a maximum likelihood associated therewith and thereby demodulate the signal, the maximum likelihood algorithm being such that the encoding is used in the algorithm to remove the redundancy in the signal.

# Fig.1.

| 11 | 12 | 13 | 14 | 15 |
|---|---|---|---|---|

Bits in → | Convolutional encoder | → | Multi-level mapper | → | Multiple by impulse | → | Gaussian filter | → | FM Modulator | RF →

1

Radio path — 16

RF → | Bandnass filter | → | Receiver filter | → | Viterbi algorithm | → | De-map to bits | → Bits out →

17        18        19        10        2

# Fig.2a.

MSB ────────────────→

────────────────→

────────────────→

────────────────→

(+)

LSB ─────────────→ [ ] [ ]

────────────────→

# Fig.2b.

State

00 •——— 00 ———• 
01 •—— 00 —— 10 — 10 —•
10 •——— 01 ———•
11 •——— 11 ——— 11 —•
           01

Data: ╲ 0
      ╱ 1

# Fig.3.

# Fig.4.

# Fig.5.

# Fig.6.

EP 1 901 509 A1

# Fig.7.

Current state

$\theta_{n-1}, S_{n-1}, S_{n-2}$

Information symbols

Next state

$\theta_n, S_n, S_{n-1}$

256 states in total

Fig.8.
(Prior Art)

# Fig.9.

t=1　t=2　　t=3　t=4　　t=5　t=6　t=7

# Fig.10.

state

00

01

10

11

t=1　t=2　　t=3　t=4　　t=5　t=6　t=7

# Fig.11.

32 branches (or paths), representing the 32
information symbols

256 States

**European Patent Office**

**EUROPEAN SEARCH REPORT**

Application Number

EP 06 25 4776

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 531 572 A2 (SIEMENS MOBILE COMM S P A [IT] SIEMENS MOBILE COMM SPA [IT]) 18 May 2005 (2005-05-18) * paragraphs [0001], [0031], [0042], [0057], [0059], [0073]; figures 1,7 * & EYUBOGLU M V ET AL: "REDUCED-STATE SEQUENCE ESTIMATION FOR TRELLIS-CODED MODULATION ON INTERSYMBOL INTERFERENCE CHANNELS" COMMUNICATIONS FOR THE INFORMATION AGE. HOLLYWOOD, NOV. 28 - DEC. 1, 1988, PROCEEDINGS OF THE GLOBAL TELECOMMUNICATIONS CONFERENCE AND EXHIBITION(GLOBECOM), NEW YORK, IEEE, US, vol. VOL. 2, 28 November 1988 (1988-11-28), pages 878-882, XP000011930 * the whole document * ----- | 1-10 | INV. H04L27/14 H03M13/41 |
| X | WANG JIA ET AL: "Performance of a bluetooth system in multipath fading channels and interference" MOBILE AND WIRELESS COMMUNICATIONS NETWORK, 2002. 4TH INTERNATIONAL WORKSHOP ON SEP. 9-11, 2002, PISCATAWAY, NJ, USA,IEEE, 9 September 2002 (2002-09-09), pages 579-582, XP010611914 ISBN: 0-7803-7605-6 * page 579, right-hand column, paragraph 1 * * page 580, left-hand column, section 2.2 * ----- | 1-10 | |
| A | US 6 476 739 B1 (LUI GEE L [US] ET AL) 5 November 2002 (2002-11-05) * column 4, line 25 - line 29 * * column 5, line 44 - line 52 * ----- | 1-10 | |

TECHNICAL FIELDS SEARCHED (IPC)

H04L
H03M

The present search report has been drawn up for all claims

| Place of search | Date of completion of the search | Examiner |
|---|---|---|
| Berlin | 5 February 2007 | Feng, Mei |

EPO FORM 1503 03.82 (P04C01)

## ANNEX TO THE EUROPEAN SEARCH REPORT
## ON EUROPEAN PATENT APPLICATION NO.

EP 06 25 4776

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2007

| Patent document cited in search report | | Publication date | Patent family member(s) | Publication date |
|---|---|---|---|---|
| EP 1531572 | A2 | 18-05-2005 | NONE | |
| US 6476739 | B1 | 05-11-2002 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **P. A. LAURENT.** Exact and approximate construction of digital phase modulations by superposition of amplitude modulated pulses (AMP. *IEEE Trans. Commun.,* February 1986, vol. COM-34, 150-160

- **S. V. PIZZI ; S. G. WILSON.** Convolutional coding combined with continuous phase modulation. *IEEE Trans. Commun.,* January 1985, vol. COM-33, 20-29
- **U. MENGALI ; M. MORELLI.** Decomposition of M-ary CPM signals into PAM waveforms. *IEEE Trans. Inform. Theory,* September 1995, vol. IT-41, 1265-1275